# DEMANDE DE BREVET EUROPEEN

(11) **EP 1 760 041 A2**
(43) Date de publication de la demande: **07.03.2007**
(21) Numéro de dépôt: 06300835.3
(22) Date de dépôt: 28.07.2006
(51) Int. Cl.: B81C 5/00

(54) **Procédé d'encapsulation d'un composant, notamment électrique ou électronique au moyen d'un cordon de soudure amélioré**

(30) Priorité: 30.08.2005 FR 0552610
(71) Demandeur: COMMISSARIAT A L'ENERGIE ATOMIQUE, 75752 Paris Cédex 15 (FR)
(72) Inventeur: Marion, François, 38950, Saint Martin le Vinoux (FR)
(74) Mandataire: Vuillermoz, Bruno

(57) **Abrégé**

Ce procédé pour encapsuler un composant **3,** notamment électrique ou électronique, consiste :
- tout d'abord à ménager une enceinte au sein de laquelle règne le vide ou dont l'atmosphère est contrôlée ;
- puis à positionner sur une surface de mouillabilité **5** mise en place sur un support ou substrat **1** comportant au moins un composant **3,** et s'étendant à la périphérie du ou des composants, un cordon de scellement continu **8,** réalisé en un métal ou en un alliage métallique,
- à positionner sur le cordon de scellement **8** un boîtier ou capot **2** de dimensions appropriées ;
- et enfin, à élever la température au sein de ladite enceinte afin d'aboutir à la fusion du matériau constitutif du cordon de scellement **8,** induisant d'une part, l'abaissement du capot ou boîtier **2** en direction du support **1,** et corollairement son scellement étanche et hermétique audit support, propre à assurer l'étanchéité de la cavité interne **9** ainsi définie vis-à-vis de l'extérieur.

La surface de mouillabilité **5** mise en place sur le substrat **1** à la périphérie du ou des composants **3** présente des variations selon une direction du plan dans lequel elle s'inscrit autre que la direction parallèle à la direction d'extension principale du cordon de scellement **8.**

## Description

### DOMAINE DE L'INVENTION

L'invention concerne le domaine de la microélectronique, et plus particulièrement celui de l'encapsulation, notamment étanche et hermétique de composants, notamment électriques ou électroniques.

Ainsi, elle se rapporte notamment au domaine des microcomposants, plus classiquement dénommés puces électriques, mais également aux micro - capteurs, micro - actuateurs, tels que les MEMS (selon l'expression anglo-saxonne *Micro Electro Mechanical System),* etc.

### ETAT ANTERIEUR DE LA TECHNIQUE

Les microcomposants dont il est question dans la présente invention, sont classiquement déposés sur un substrat de nature appropriée, par exemple de type semi-conducteur (silicium monocristallin, saphir, etc) pour des composants électroniques.

Ces substrats sont munis de pistes conductrices de l'électricité, qui rayonnent à partir du microcomposant en direction de la périphérie du substrat, afin de permettre outre l'alimentation électrique du composant, le cas échéant, requise, également et surtout le traitement et l'exploitation des signaux que ledit composant est appelé à générer, ou encore le pilotage des fonctions qu'il incorpore.

Dans certains cas, ces composants sont encapsulés au sein d'une structure de type boîtier ou capot de protection ou équivalents, qui permet d'assurer une protection contre les chocs, la corrosion, les rayons électromagnétiques parasites, etc.

Ce capot ou boîtier peut en outre intégrer une fenêtre transparente à un rayonnement à détecter par ledit composant, ou intégrer une ou plusieurs lentilles de concentration dudit rayonnement au niveau du composant.

Certains de ces microcomposants nécessitent pour leur fonctionnement de travailler sous vide, ou sous atmosphère contrôlée (pression, gaz neutre, etc.) ou de manière étanche par rapport à l'atmosphère ambiante. De fait, le boîtier ou capot précité est mis à contribution afin de définir une cavité au-dessus dudit composant, renfermant l'atmosphère contrôlée ou un vide plus ou moins poussé.

Dans le cadre particulier de ces microcomposants encapsulés, différents problèmes techniques viennent se greffer lors de leur réalisation.

Tout d'abord, intervient la qualité de l'herméticité de la liaison capot ou boîtier avec le composant pour s'assurer de l'isolation effective dudit composant des agents extérieurs, et ce, de manière indépendante de la nature de l'atmosphère alors emprisonnée dans le volume défini.

Il convient ensuite de pouvoir contrôler la nature de l'atmosphère confinée dans ledit volume, imposant de fait que cette atmosphère soit communiquée au sein de ce volume préalablement au scellement, et de manière générale à la fixation du capot sur le composant.

Différentes techniques ont été mises en oeuvre à ce jour, pour permettre la réalisation d'une telle encapsulation d'un composant électrique ou électronique.

Parmi celles-ci, figure le principe du soudage wafer sur wafer (wafer étant l'expression anglo-saxonne consacrée pour désigner une plaquette d'un substrat semi-conducteur). On vient ainsi coiffer le wafer contenant le ou les composants électriques ou électroniques avec un autre wafer dans lequel ont déjà usinées un ou plusieurs cavités propres à définir le volume à confiner.

La fixation intervient par soudage, notamment anodique, par fusion ou par scellement par frittage du verre. Le principe ainsi mis en oeuvre, s'il donne satisfaction sur le plan de l'étanchéité, en revanche présente quelques difficultés s'agissant de la connectique. En effet, l'accès aux plots de connexion ou pads pour permettre le soudage des fils de connectique s'avère complexe, de sorte que la topologie susceptible d'être mise en oeuvre est limitée. Au demeurant, une haute température de soudage étant généralement requise, ce sorte que cela limite de manière assez drastique le nombre de composants électroniques susceptibles d'être mis en oeuvre au sein des volumes ainsi définis.

Une autre alternative consiste à réaliser des capots par dépôt de couches minces. Ainsi, une cavité pour composant actif est formée sur un wafer, puis bouchée en utilisant des techniques de scellement en couches minces. Par exemple, on fait croître une couche par LPCVD *(« Low Pressure Chemical Vapor Deposition* ») ou simplement en recouvrant la cavité.

La dimension du capot peut se réduire à celle du composant actif. Si cette technique est certes complexe à mettre en oeuvre, elle présente cependant l'avantage de pouvoir sceller collectivement de nombreux wafers comportant des composants actifs de très petites dimensions.

Enfin, une autre technique consiste à souder un capot ou boîtier sur un wafer, en mettant en oeuvre soit des puces - capot, c'est-à-dire que chaque composant actif reçoit un capot, soit encore par la mise en oeuvre d'une puce plus large, susceptible de recouvrir plusieurs composants actifs sur un seul wafer.

Cette technique s'effectue classiquement sur plusieurs étapes : elle consiste à aligner le ou les capots au-dessus des composants, le tout au sein d'une enceinte propre à assurer une atmosphère contrôlée ou au contraire une enceinte sous vide, puis à sceller le ou les capots sur le(s) composant(s) selon des technologies connues de l'homme du métier, mettant notamment en oeuvre un joint de soudure réalisé par exemple en indium ou en alliage étain/plomb.

On conçoit aisément que, dès lors qu'une multiplicité de ce type d'opérations doit être effectuée, ou que l'on mette en oeuvre un support multi - composants, l'installation destinée à assurer ces opérations devient très lourde, attendu que l'ensemble de celles-ci doit être opéré au sein de l'enceinte assurant comme déjà dit le maintien de l'atmosphère contrôlée ou le maintien sous vide. En outre, une telle opération est fortement consommatrice de temps puisque aussi bien, en cas de pluralité de capots, pour un procédé mettant en oeuvre N opérations de capotage, la durée totale de l'opération devient :
N x (temps de mise sous atmosphère contrôlée ou sous vide + temps d'alignement du capot sur les composants + temps de soudure)

Ce faisant, le coût induit s'avère important.

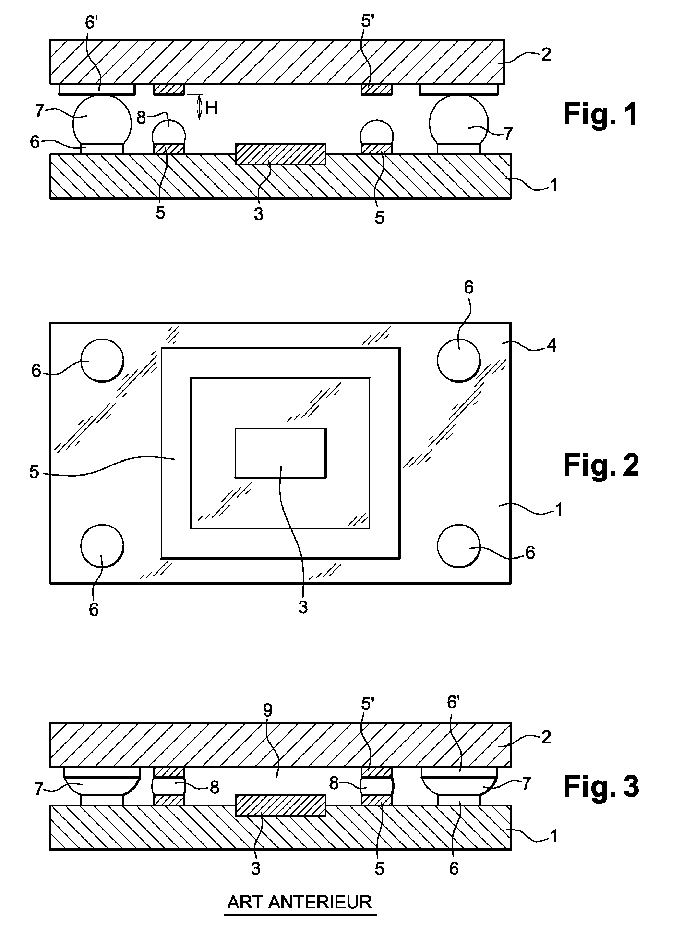

Afin d'optimiser cette durée, on a proposé une solution dans le document FR 2 780 200, qui illustre dans l'une de ses formes de réalisation la mise en oeuvre d'un composant électrique encapsulé. On a représenté en relation avec les figures 1 à 3, cette forme de réalisation particulière ainsi décrite.

Ainsi, sur un wafer **1** réalisé par exemple en silicium, est rapporté par les techniques classiques un composant électronique **3**. Sur la surface supérieure **4** du wafer **1** et à la périphérie du composant électronique **3** est positionnée une surface ou zone de mouillabilité **5**, destinée à recevoir un cordon de soudure **8** réalisé en indium ou en un alliage étain/plomb.

Ce document mentionne également la présence d'une calle constituée de billes **7**, également réalisées en un matériau thermofusible, avantageusement identique à celui constitutif du cordon de soudure **8**, et sur lesquelles repose un capot **2**, propre à définir, avec le wafer **1** et le cordon de soudure **8**, la cavité recherchée **9** contenant l'atmosphère contrôlée ou au contraire le vide.

Afin de ménager au sein de ladite cavité **9** l'atmosphère souhaitée, les billes **7** définissant la calle supportant le capot **2** sont positionnées à l'extérieur du cordon de soudure, l'ensemble étant placé au sein d'une enceinte au sein de laquelle règne l'atmosphère contrôlée souhaitée ou le vide. Une simple élévation de température, suffisante pour faire fondre le matériau constitutif des billes **7** et du cordon de soudure **8**, permet d'induire l'abaissement du capot **2** jusqu'à ce que ce dernier entre en contact avec ledit cordon de soudure, afin d'assurer la fermeture étanche de la cavité ainsi définie.

Dans la pratique, les billes **7** sont également positionnées sur une surface de mouillabilité **6.** De même, afin de favoriser le contact, et surtout l'étanchéité, la face inférieure du capot **2** reçoit également des surfaces de mouillabilité, respectivement **5'** et **6'**.

Ce faisant, la mise en oeuvre d'une telle technologie permet de gagner un temps considérable par rapport au procédé précédemment décrit, puisque la durée d'un procédé de N capotages, c'est-à-dire de capotage pour l'encapsulation de N composants actifs n'est plus alors égal qu'à :
N x temps d'alignement du capot + 1 x temps de mise en atmosphère + 1 x temps de soudure.

Le gain de temps Δt devient donc égal à :
Δ t = (N - 1) x (temps de mise en atmosphère + temps de soudure)

Cette diminution de la durée d'encapsulation est très significative, puisque la durée de mise sous atmosphère contrôlée ou de mise sous vide est très supérieure à la durée du dépôt du capot.

Si sur le plan théorique, la solution technique proposée par ce document s'avère des plus intéressante, la pratique démontre cependant la quasi-impossibilité de réaliser un cordon d'étanchéité ou de soudure uniforme préalablement à la fermeture hermétique par refusion.

En effet, on a pu montrer que le cordon de matière fusible, notamment d'alliage, ne se forme pas de manière uniforme sur le ruban constituant la surface ou zone mouillable sous-jacente réalisée sur le substrat selon la technique dite UBM (« *Under Bump Metallization* »). En effet, en raison des phénomènes bien connus de tension superficielle, visant à réduire au maximum la surface définissant une enveloppe considérée, le ruban forme plutôt des agglomérats de soudure dans certaines zones et laisse des zones complètement exemptes de matière dans d'autres.

En effet, à la température de fusion de l'alliage constitutif du cordon de soudure, le volume global de soudure en présence représente une surface externe minimal correspondant à celle d'une bille et non à celle d'un cordon linéaire tel que souhaité.

### EXPOSE DE L'INVENTION

L'objet de la présente invention est justement de s'affranchir de cet inconvénient, et de proposer une solution technique permettant de conférer au cordon de soudure une certaine continuité, propre à favoriser l'étanchéité recherchée au sein de la cavité définie par le boîtier d'encapsulation.

Ce procédé pour encapsuler un composant, notamment électrique ou électronique, consiste selon l'invention :
- tout d'abord à ménager une enceinte au sein de laquelle règne le vide ou dont l'atmosphère est contrôlée ;
- puis à positionner sur une surface de mouillabilité préalablement mise en place sur un support ou substrat comportant au moins un composant, et s'étendant à la périphérie du ou des composants actifs, un cordon de scellement continu, réalisé en un métal ou en un alliage métallique, avantageusement à faible température de fusion,
- à positionner sur le cordon de scellement un boîtier ou capot de dimensions appropriées ;
- et enfin, à élever la température au sein de ladite enceinte afin d'aboutir à la fusion du matériau constitutif du cordon de scellement, induisant d'une part, l'abaissement du capot ou boîtier en direction du support, et corollairement son scellement étanche et hermétique audit support, propre à assurer l'étanchéité de la cavité interne ainsi définie vis-à-vis de l'extérieur.

Selon l'invention, la surface de mouillabilité mise en place sur le substrat à la périphérie du ou des composants, et sur laquelle est positionné le cordon de scellement, présente des variations selon une direction du plan dans lequel elle s'inscrit autre que la direction parallèle à la direction d'extension principale du cordon de scellement.

En d'autres termes, l'invention consiste non pas, comme dans l'art antérieur, à rapporter sur la surface supérieure du support ou du substrat une surface ou zone de mouillabilité uniforme, c'est-à-dire de largeur constante, mais au contraire à conférer à celle-ci un certain nombre de variations, notamment selon cette largeur.

Ce faisant, on a pu montrer qu'en sélectionnant une telle surface de mouillabilité, les phénomènes de tension superficielle affectant la continuité du cordon lorsque celui-ci atteint la fusion, étaient diminués, permettant ainsi de conférer audit cordon la continuité recherchée, et corollairement à conférer à l'assemblage constitué du support et de son capot l'étanchéité et l'herméticité recherchées.

Selon une caractéristique avantageuse de l'invention, les variations de la dimension en question sont périodiques. En d'autres termes, la surface de mouillabilité présente un motif répétitif de mêmes dimensions tout le long de sa longueur ou dimension principale.

Selon une autre caractéristique de l'invention, la surface de mouillabilité est constituée d'une succession de rectangles, la largeur de deux rectangles consécutifs variant de manière discrète entre deux valeurs déterminées.

Selon une variante, la surface de mouillabilité est constituée par une succession de disques, le diamètre de deux disques consécutifs variant de manière discrète entre deux valeurs déterminées.

Encore selon une autre variante, la surface de mouillabilité est constituée par une succession de carrés ou de losanges, dont l'une des diagonales est orientée selon la direction d'extension du cordon, l'autre diagonale de deux carrés ou losanges consécutifs variant de manière discrète entre deux valeurs déterminées.

Selon une caractéristique particulière de l'invention, si L correspond à la largeur de la restriction, c'est-à-dire à la largeur du motif intermédiaire entre deux motifs correspondant à la largeur nominale de la surface de mouillabilité, alors la largeur dudit motif principal est d'au moins de valeurs K . L, où K est une constante supérieure strictement à 1,1, afin d'aboutir au résultat recherché.

### BREVE DESCRIPTION DES FIGURES

La manière dont l'invention peut être réalisée et les avantages qui en découlent ressortiront mieux des exemples de réalisation qui suivent, donnés à titre indicatif et non limitatif à l'appui des figures annexées.
Comme déjà dit, les figures 1, 2 et 3 illustrent l'état antérieur de la technique, les figures 1 et 3 étant des représentations schématiques en section d'un substrat support et d'un capot, respectivement préalablement et postérieurement à l'élévation de température entraînant la refusion du cordon de scellement, la figure 2 étant une vue schématique de la face supérieure du substrat.
La figure 4 est une représentation schématique vue du dessus de la surface de mouillabilité conforme à une première forme de réalisation de l'invention, dont la figure 5 est une vue de détail de l'un des motifs, et dont les figures 6 et 7 sont respectivement des coupes selon les lignes VI-VI et VII-VII au sein de la figure 4.
Les figures 8a, 8b, 8c et 8d sont quatre représentations schématiques de variantes de motifs de la surface de mouillabilité conformément à l'invention.
Les figures 9a et 9b sont des représentations schématiques en section de l'application particulière de l'invention à la réalisation d'un MEMS ou d'un composant optique.
La figure 10 est une représentation schématique en section d'une application de l'invention avec auto-alignement du capot et capotage simultanés.

### DESCRIPTION DETAILLEE DE L'INVENTION

Comme déjà indiqué dans le préambule de la présente description, le composant **3** qu'il convient d'encapsuler est constitué d'un MEMS, d'un composant optique, d'un micro-capteur, notamment de rayonnement (et par exemple un bolomètre), mais également d'un accéléromètre, ou d'activateur ou micro-activateur, etc. Ce composant actif **3** est rapporté sur un support **1,** typiquement constitué d'un substrat réalisé en silicium par exemple, et de manière générale en tout matériau traditionnel pour l'assemblage des microcomposants.

De manière classique, les signaux électriques de polarisation du composant, le cas échéant requis, sont acheminés à ce dernier par le biais de pistes conductrices électriques, rapportées également sur ledit substrat en direction de la périphérie de celui-ci. De telles pistes électriques servent également à permettre le transit des signaux générés par ledit composant, ou au contraire, commandant le composant, lorsque celui-ci est constitué d'un activateur.

Dans le cadre général de l'invention, ce composant doit être protégé des influences extérieures ou peut nécessiter de fonctionner sous une atmosphère contrôlée, et par exemple sous des pressions spécifiques, voire en présence d'un gaz inerte, ou d'un gaz spécifique, ou même doit fonctionner sous vide, tel que pour des composants refroidis.

A cet effet, un capot ou boîtier **2** est scellé hermétiquement sur le support **1,** de telle sorte à définir une cavité **9** isolée de l'extérieur, et au sein de laquelle est situé le composant actif **3.** Ce boîtier ou capot est scellé au moyen d'un cordon de soudure ou de scellement **8,** en mettant en oeuvre les technologies connues de soudure métal/métal, ledit cordon étant réalisé en indium voire en alliage étain/plomb ou tout alliage de brasure, notamment basse température.

A cet effet, on rapporte sur le substrat - support **1** une zone ou surface de mouillabilité **5,** s'étendant à la périphérie dudit composant **3.** Le design de cette surface correspond à celui des parois latérales définissant le boîtier ou capot.

Cette surface de mouillabilité peut être réalisée à base d'un empilement tricouches titane/nickel/or, effectué par exemple par dépôt et photolithographie, ou tout autre empilement métallique en couches minces, bien connu dans le domaine de la microélectronique.

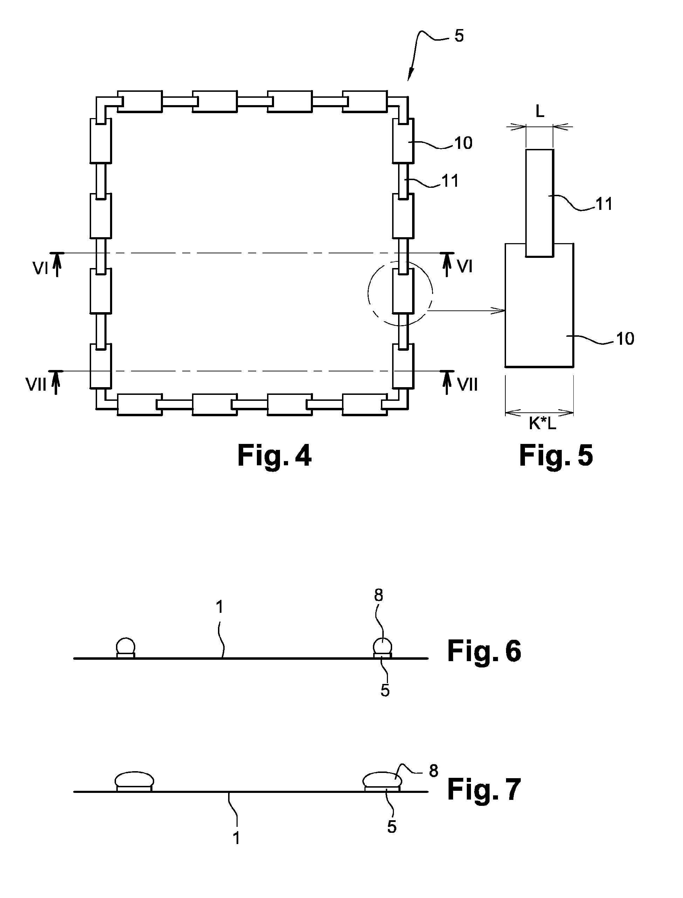

Selon une caractéristique essentielle de l'invention, et ainsi qu'on peut bien l'observer sur la figure 4, cette zone ou surface de mouillabilité n'est pas uniforme, mais présente un certain nombre de variations de sa largeur, en l'espèce constituées de discontinuités.

Ainsi, dans l'exemple décrit, cette zone ou surface de mouillabilité est constituée d'une succession de rectangles alternativement de largeur K.L pour les rectangles les plus larges **10,** et de largeur L pour les rectangles les plus étroits **11.** K est une constante supérieure à 1,1.

En outre, il y a superposition partielle desdits motifs, avec pour objectif la continuité du cordon de soudure ou de scellement.

L'opération effective de fermeture du boîtier ou capot sur le support, intervenant postérieurement à la mise en place du cordon de scellement sur la zone de mouillabilité ainsi définie, s'effectue par élévation de la température de l'enceinte dans laquelle sont situés le support et le boîtier en question, à une température supérieure à la température de fusion de l'alliage ou du métal constitutif dudit cordon. Il se forme un cordon régulier et homogène sur toute la longueur de la zone ou surface de mouillabilité, c'est-à-dire sur toute la périphérie du boîtier.

La mise en place du cordon de soudure ou de scellement sur la surface de mouillabilité peut être réalisée selon l'une quelconque des méthodes connues : évaporation, sérigraphie, électrolyse.

Selon une alternative cependant, le dépôt du cordon de soudure sur la surface de mouillabilité peut être réalisé selon la technologie dite d'impression métallique. Cette technologie permet de réduire de manière importante les coûts associés au dépôt de soudure, en supprimant notamment toute étape de photomasquage (photolithographie) tout en permettant l'utilisation de toutes les techniques de dépôt de soudure pleine tranche disponibles.

L'opération de moulage dudit cordon de soudure peut être ainsi réalisée soit par indexation, soit par une technique de moulage globale, ces deux techniques étant décrites dans la demande de brevet déposée le même jour que la présente demande.

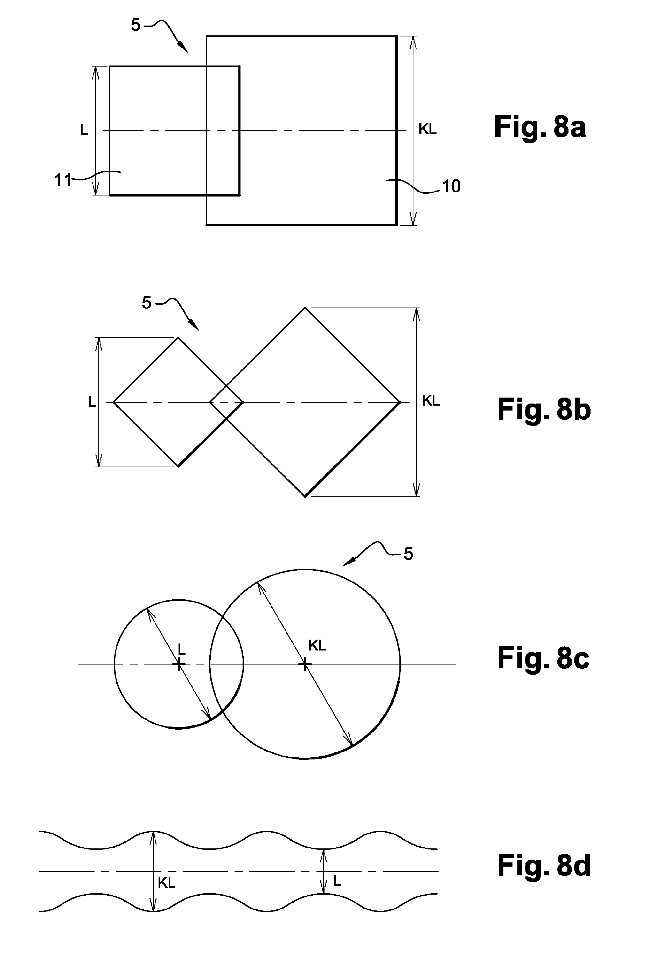

Selon une variante de l'invention, la surface de mouillabilité n'est pas constituée par une succession de rectangles, mais par la succession de losanges ou carrés se recouvrant partiellement, ainsi que schématiquement représenté sur la figure 8b. L'une des diagonales de ces motifs est orientée selon la dimension principale du cordon de soudure.

Selon cette configuration, si l'autre diagonale a pour valeur L pour les carrés ou losanges **11** correspondant aux zones de restriction, cette même diagonale a alors au moins pour valeur K.L pour les carrés ou losanges **10** de grandes dimensions, avec la constante K au moins supérieure à 1,1.

Selon une autre variante de l'invention, telle que représentée sur la figure 8c, la surface de mouillabilité est constituée par une succession de disques, se recouvrant partiellement, dont le diamètre varie entre deux disques consécutifs d'une valeur L à une valeur au moins égale à K.L, la constante K étant supérieure à 1,1.

Selon encore une autre variante de l'invention représentée sur la figure 8d, la largeur de la surface de mouillabilité ne varie plus de manière discrète,, mais de manière continue entre deux valeurs extrêmes, respectivement L et K.L.

En tout état de cause, et comme déjà indiqué, la constante K est systématiquement supérieure à la valeur de 1,1. En effet, si cette constante K est inférieure à cette valeur, les phénomènes de tension superficielle réapparaissent, avec en corollaire les risques de discontinuité du cordon de soudure lors de la refusion.

La pratique démontre que l'on obtient d'excellents résultats, et en tout cas conformes aux prévisions pour une valeur de K comprise entre 1,6 et 2.

La technologique conforme à l'invention permet la mise en oeuvre du capotage collectif, c'est-à-dire la mise en oeuvre d'un seul capot au-dessus de plusieurs composants, notamment actifs.

Cette technologie est largement décrite dans le document FR 2 780 200 mentionné précédemment.

Succinctement, cette méthode de capotage collectif consiste :
- à poser simultanément tous les capots sur les sites à capoter, et donc sur les différents composants actifs ;
- à transporter la plaque sur laquelle sont positionnés les capots au sein de l'enceinte dans laquelle le capotage doit intervenir,
- éventuellement à chauffer ladite enceinte à une température inférieure à la température de fusion du cordon de soudure, et ce, pendant la durée nécessaire pour activer d'éventuels getters ou réaliser d'éventuels dégazage ;
- à introduire dans l'enceinte le ou les gaz destinés à être confinés dans la cavité **9,** ou au contraire à réaliser le vide au sein de l'enceinte en question, notamment lorsqu'il s'agit de bolomètre et de certains capteurs MEMS ;
- et à chauffer au-dessus la température de fusion du métal ou de l'alliage constitutif du cordon de soudure, de telle sorte à faire s'affaisser l'ensemble des capots en raison du design des éléments de soudure mis en oeuvre, et créant simultanément une pluralité de cavités.

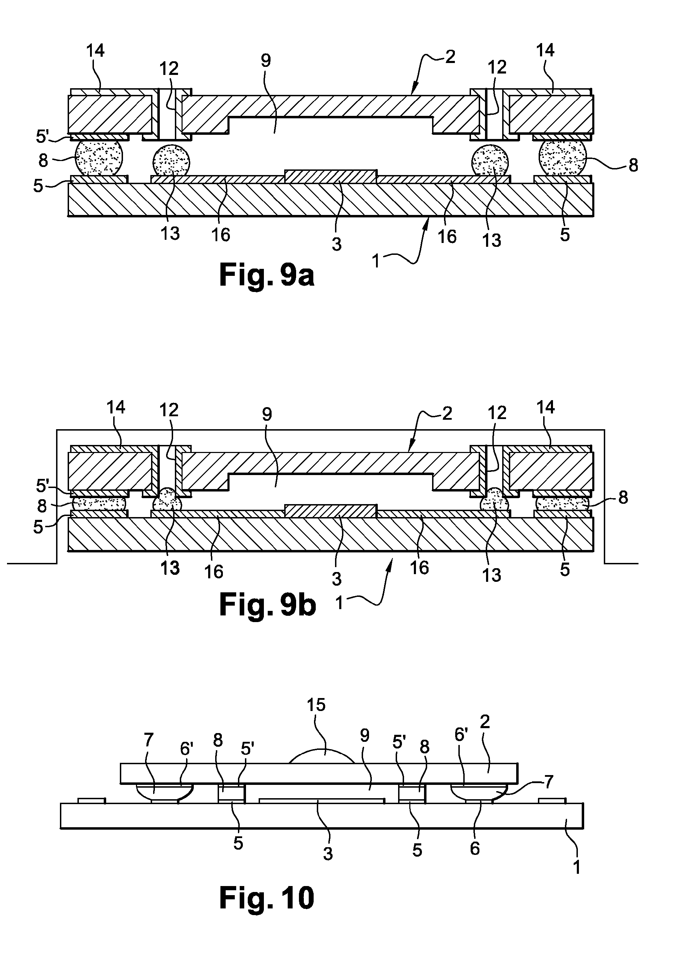

Cette technologie peut ainsi utilement être mise en oeuvre pour la réalisation de dispositifs optiques ou MEMS, intégrant une connectique dense, y compris sur la surface du boîtier (voir figure 9a et 9b). Comme on peut l'observer, ledit boîtier **2** comporte des orifices traversants **12,** ménagés à l'aplomb billes ou micro-billes conductrices **13,** elles-mêmes reposant sur des pistes conductrices **16** ménagées sur la surface supérieure **4** du substrat, et connectées au composant actif **3.**

La surface interne de ces orifices traversants **12** est métallisée, cette métallisation débordant légèrement au niveau de la face interne du boîtier ou capot **2** de sorte à optimiser le contact électrique avec la bille ou micro-bille **13** sous-jacente, et corollairement afin d'assurer une conduction électrique améliorée. On a représenté par la référence **14** les pistes conductrices ménagées sur la face supérieure du capot ou boîtier **2,** en continuité électrique avec les vias **12** ainsi réalisés.

Le procédé de l'invention permet également de favoriser l'auto-alignement du capot ou boîtier **2** au dessus du ou des composants actifs **3.**

On a ainsi représenté au sein de la figure 10 un schéma visant à illustrer un tel auto-alignement. Ainsi, le ou les organes optiques **15** sont alignés avec les surfaces de mouillabilité **6',** qui vont s'autoaligner lors de l'assemblage avec les surfaces de mouillabilité **6.** Les surfaces **6** étant elles-mêmes allignées avec le composant **3,** au final, les composants **15** et **3** sont parfaitement alignés.

En raison des phénomènes de tension superficielle déjà évoqués, ce différentiel de positionnement ou d'aplomb des surfaces de mouillabilité respectives génèrent des contraintes favorisant un tel auto-alignement. Au surplus, ces phénomènes permettent également une certaine tolérance en termes de positionnement des surfaces de mouillabilité respectives.

Ce faisant, de par la possibilité d'aboutir à un tel auto-alignement, il devient plus aisé d'intégrer au sein du capot ou du boîtier des organes assurant une fonction optique, par exemple propre à focaliser le rayonnement à détecter au niveau du composant **3**.

On conçoit donc tout l'intérêt du procédé de l'invention, tout particulièrement en termes de gain de temps pour la réalisation de l'encapsulation de composants actifs, et son corollaire, un gain en compétitivité, les coûts de fabrication étant significativement abaissés.

## Revendications

1. Procédé pour encapsuler un composant **3**, notamment électrique ou électronique, consistant :
- tout d'abord à ménager une enceinte au sein de laquelle règne le vide ou dont l'atmosphère est contrôlée ;
- puis à positionner sur une surface de mouillabilité **5** préalablement mise en place sur un support ou substrat **1** comportant au moins un composant **3**, et s'étendant à la périphérie du ou des composants, un cordon de scellement continu **8**, réalisé en un métal ou en un alliage métallique, avantageusement à faible température de fusion,
- à positionner sur le cordon de scellement **8** un boîtier ou capot **2** de dimensions appropriées ;
- et enfin, à élever la température au sein de ladite enceinte afin d'aboutir à la fusion du matériau constitutif du cordon de scellement **8**, induisant d'une part, l'abaissement du capot ou boîtier **2** en direction du support **1**, et corollairement son scellement étanche et hermétique audit support, propre à assurer l'étanchéité de la cavité interne **9** ainsi définie vis-à-vis de l'extérieur ;
***caractérisé* en ce que** la surface de mouillabilité **5** mise en place sur le substrat **1** à la périphérie du ou des composants **3**, et sur laquelle est positionné le cordon de scellement **8**, présente des variations selon une direction du plan dans lequel elle s'inscrit autre que la direction parallèle à la direction d'extension principale du cordon de scellement **8**.

2. Procédé pour encapsuler un composant **3** selon la revendication 1, ***caractérisé* en ce que** les variations affectant la zone ou surface de mouillabilité **5** sont réalisées selon la direction perpendiculaire à la direction d'extension principale du cordon de scellement **8**.

3. Procédé pour encapsuler un composant **3** selon l'une des revendications 1 et 2, ***caractérisé* en ce que** les variations affectant la zone ou surface de mouillabilité **5** sont périodiques.

4. Procédé pour encapsuler un composant **3** selon la revendication 3, ***caractérisé* en ce que** la zone ou surface de mouillabilité **5** est constituée par la succession de motifs répétitifs de mêmes dimensions.

5. Procédé pour encapsuler un composant **3** selon l'une des revendications 1 à 4, ***caractérisé* en ce que** la surface de mouillabilité **5** est constituée d'une succession de rectangles **10, 11,** la largeur de deux rectangles consécutifs variant de manière discrète entre deux valeurs déterminées.

6. Procédé pour encapsuler un composant **3** selon l'une des revendications 1 à 4, ***caractérisé* en ce que** la surface de mouillabilité **5** est constituée par une succession de disques, le diamètre de deux disques consécutifs variant de manière discrète entre deux valeurs déterminées.

7. Procédé pour encapsuler un composant **3** selon l'une des revendications 1 à 4, ***caractérisé* en ce que** la surface de mouillabilité **5** est constituée par une succession de carrés ou de losanges, dont l'une des diagonales est orientée selon la direction d'extension du cordon de scellement **8,** l'autre diagonale de deux carrés ou losanges consécutifs variant de manière discrète entre deux valeurs déterminées.

8. Procédé pour encapsuler un composant **3** selon l'une des revendications 1 à 7, ***caractérisé* en ce que** si L correspond à la largeur de la restriction, alors la largeur maximale du motif principal est d'au moins de valeurs K . L, où K représente une constante supérieure strictement à 1,1.
